# EUROPEAN PATENT SPECIFICATION

(11) **EP 2 384 456 B1**
(45) Date of publication and mention of the grant of the patent: **01.03.2017**
(21) Application number: 10703509.9
(22) Date of filing: 22.01.2010
(51) Int. Cl.: G03F 7/00, G11B 9/00, G01Q 80/00

(54) **METHOD FOR PATTERNING NANO-SCALE PATTERNS OF MOLECULES ON A SURFACE OF A MATERIAL**
VERFAHREN ZUR ERZEUGUNG NANOSKALIGER STRUKTUREN VON MOLEKÜLEN AUF DER OBERFLÄCHE EINES MATERIALS
PROCÉDÉ D'APPLICATION DE MOTIFS NANOMÉTRIQUES CONSTITUÉS DE MOLÉCULES À LA SURFACE D'UN MATÉRIAU

(30) Priority: 30.01.2009 US 363389
(43) Date of publication of application: 09.11.2011
(73) Proprietor: International Business Machines Corporation, Armonk, NY 10504 (US)
(72) Inventor: DUERIG, Urs T, CH-8803 Rueschlikon (CH); GOTSMANN, Bernd W, CH-8803 Rueschlikon (CH); HEDRICK, James L., San Jose, California 95120-6099 (US); KNOLL, Armin W, CH-8803 Rueschlikon (CH); PIRES, David, CH-4123 Allschwil (CH)
(74) Representative: Ragot, Sébastien Pierre
(86) International application number: PCT/IB2010/050293
(87) International publication number: WO 2010/086773

(56) References cited:
- WO-A2-2007/027757
- US-A- 5 641 856
- US-A1- 2006 091 322
- YUEMING HUA ET AL: "Direct three-dimensional nanoscale thermal lithography at high speeds using heated atomic-force microscope cantilevers" PROCEEDINGS OF THE SPIE - THE INTERNATIONAL SOCIETY FOR OPTICAL ENGINEERING SPIE - USA LNKD- DOI:10.1117/12.713374, vol. 6517, 2007, XP002583732 ISSN: 0277-786X
- YUEMING HUA ET AL: "Nanolithography in thermally sacrificial polymers using nanoscale thermal probes" PROCEEDINGS OF THE SPIE - THE INTERNATIONAL SOCIETY FOR OPTICAL ENGINEERING SPIE - USA LNKD- DOI:10.1117/12.661803, vol. 6153, 2006, pages 61531G-1, XP002583733 ISSN: 0277-786X
- ANDRE X ET AL: "Phenolic molecular glasses as resists for next-generation lithography", PROCEEDINGS OF THE SPIE - THE INTERNATIONAL SOCIETY FOR OPTICAL ENGINEERING SPIE - THE INTERNATIONAL SOCIETY FOR OPTICAL ENGINEERING USA, vol. 6519, 2007, page 65194B (10 pp.), ISSN: 0277-786X

## Description

### BACKGROUND

The present invention relates to the field of probe-based methods for patterning a surface of a material, such as scanning probe lithography (herein after SPL). In particular, embodiments are directed to high resolution patterning of molecules on a surface of a material, such as nano-scale patterns with feature sizes of less than 30 nanometers (nm).

Lithography is a process for producing patterns of two dimensional shapes, including drawing primitives such as lines and pixels within a layer of material, such as, for example, a resist coated on a semiconductor device. Conventional photolithography (also called optical lithography) is running into problems as the feature size is reduced, e.g. below 65 nm. These problems arise from fundamental issues such as sources for the low wavelength of light, photoacid migration, photoresist collapse, lens system quality for low wavelength light and masks cost. To overcome these issues, alternative approaches are required.

Examples of such alternative approaches are known in the field of the so-called nanolithography, which can be seen as high resolution patterning of molecules. Nanolithography refers to fabrication techniques of nanometer-scale structures, including patterns having one dimension sizing up to about 100 nm (hence partly overlapping with photolithography). Beyond the conventional photolithography, they further include such techniques as charged-particle lithography (ion- or electron-beams), nanoimprint lithography and its variants, and SPL (for patterning at the deep nanometer-scale). SPL is for instance described in detail in Chemical Reviews, 1997, Volume 97 pages 1195 to 1230, "Nanometer-scale Surface Modification Using the Scanning Probe Microscope: Progress since 1991", Nyffenegger et al. and the references cited therein.

In general, SPL is used to describe lithographic methods wherein a probe tip is moved across a surface to form a pattern. In other words, scanning probe lithography makes use of scanning probe microscopy (SPM) techniques, which relies on the availability of the scanning tunneling microscope. In short, it aims at forming images of sample surfaces using a physical probe. SPM techniques rely on scanning such a probe, e.g. a sharp tip, just above a sample surface whilst monitoring interactions between the probe and the surface. An image of the sample surface can thereby be obtained. Typically, a raster scan of the sample is carried out and the probe-surface interaction is recorded as a function of position. Data are thus typically obtained as a two-dimensional grid of data points.

The resolution achieved varies with the underlying technique; atomic resolution can be achieved in some cases. Use can be made of piezoelectric actuators to execute motions with precision and accuracy, at any desired length scale up to better than the atomic scale. The two main types of SPM are the scanning tunneling microscopy (STM) and the atomic force microscopy (AFM).

In particular, the AFM is a device in which the topography of a sample is modified or sensed by a probe or probe mounted on the end of a cantilever. As the sample is scanned, interactions between the probe and the sample surface cause pivotal deflection of the cantilever. The topography of the sample may thus be determined by detecting this deflection of the probe. Yet, by controlling the deflection of the cantilever and the physical properties of the probe, the surface topography may be modified to produce a pattern on the sample.

Following this idea, in a SPL device, a probe is raster scanned across a resist surface and brought to locally interact with the resist material. By this interaction, resist material is removed or changed. In this respect, one may distinguish amongst: constructive probe lithography, where patterning is carried out by transferring chemical species to the surface; and destructive probe lithography, which includes physically and/or chemically deforming a substrate's surface by providing energy (mechanical, thermal, photonic, ionic, electronic, or X-rays energy, etc.). SPL is accordingly a suitable technique for nanolithography.

High resolution patterning of molecules is relevant to several areas of technology, such as alternatives to optical lithography, patterning for rapid prototyping, direct functionalization of surfaces, mask production for optical and imprint lithography, and data storage.

In particular, lithography can be used for the fabrication of microelectronic devices. In this case, electron-beam (or e-beam) and probe-based lithography are mostly in use.

For high resolution optical mask and nano-imprint master fabrication, e-beam lithography is nowadays a standard technology. However, when approaching high resolutions, writing times for e-beam mask/master fabrication increase unfavorably.

As a possible alternative, the use of probes for such patterning is still under development. At high resolution (< 30 nm), the speed of single e-beam and single probe structuring converges.

In the case of data storage, various approaches have been proposed to make use of probes for storage in the archival regime. However, a main challenge that remains is to achieve long bit-retention. Using thermomechanical indentation allows for instance to achieve satisfactory endurance and retention of data. A thermomechanical approach, however, produces indentations that are inherently under mechanical stress. Therefore it is difficult to obtain retention times in excess of ten years, as is usually desired in the archival domain.

US2006091322 (A1) discloses a resist medium in which features are lithographically produced by scanning a surface of the medium with an AFM probe positioned in contact therewith, said medium comprising a substrate; and a polymer resist layer within which features are produced by mechanical action of the probe. The polymer contains thermally reversible crosslinkages. The polymer resist can be a silicone derivative or an organic polymer. In the latter case, the thermally reversible crosslinkages may be covalent bonds, for example as obtained by Diels-Alder adducts, e.g., the product of a dienophile and a substituted furan. In embodiments, and under the control of suitable probe controlling software, the probe is moved across the resist layer and heat applied at predetermined locations to cause the probe to displace (expose/evaporate) the resist layer to produce indentations exposing the upper surface of the substrate.

### SUMMARY

In one embodiment, a probe-based method for patterning a surface of a material as in claim 1 is described. The method includes providing a material having a polymer film with a network of molecules cross-linked via intermolecular, non essentially covalent bonds. The method also includes patterning the polymer film by desorbing molecules from the network with a heated, nano-scale dimensioned probe.

In the invention, the method includes providing a material having
a polymer film with a network of molecular glass molecules. The molecules are cross-linked essentially via hydrogen bonds. An average desorption energy of the molecules in the film is approximately between 2 eV and 3 eV. The method also includes patterning the polymer film by desorbing molecules from the network with a heated, nano-scale dimensioned probe. The temperature of the probe is approximately between 300°C and 600°C. The time of exposure of the probe to the surface is approximately between 0.3 microsecond and 10 microseconds. Other embodiments of the patterning method are also described.

Also, examples of a material are described. The material includes a
polymer film. The polymer film includes a network of molecules. The molecules are cross-linked via intermolecular, non essentially covalent bonds. The polymer film also includes nano-scale dimensioned patterns of molecules in the network. Other examples of the material are also described.

A method of accessing (e.g., writing and/or reading) patterns of molecules is described. The method includes providing a material such as the material described above. The method also includes accessing the patterns of molecules of the material. Accessing the patterns of molecules of material includes writing and/or reading the patterns of molecules. Other examples of the accessing
method are also described.

Examples of methods and materials embodying aspects of the present invention are described below, by way of non-limiting example, and in reference to the accompanying drawings.

### BRIEF DESCRIPTION OF THE DRAWINGS

FIGS. 1 - 3 schematically illustrate a process according to an embodiment of the invention;
FIGS. 4 - 5 schematically depict another process according to another embodiment;
FIGS. 6a - c show embodiments of schematized sections of nano-scale dimensioned patterns in a patterned material;
FIG. 7 is an example of a molecular glass structure;
FIGS. 8 - 9 show cross sections of topographic images of surfaces patterned according to the embodiment of FIGS. 1 - 3;
FIG. 10 is a cross section of a topographic image of a surface patterned according to the embodiment of FIGS. 4 - 5; and
FIG. 11 is a graph comparing cross-sections of a patterned material and a pattern transfer into silicon.

### DETAILED DESCRIPTION

As an introduction to the following description, embodiments described herein relate to a method for patterning a surface of a material. In one embodiment, a material having a polymer film thereon is provided. A probe is then used to create patterns on the film, by desorbing molecules at the surface thereof.

The film includes a network of molecules which are cross-linked via intermolecular, noncovalent bonds, such as van der Waals forces, or hydrogen bonds. More specifically, such bonds are *not* of a covalent bonding nature (at least not essentially), that is, there is no clear electron pairing between radicals that characterizes the ordinary Heitler-London covalent bond. Rather, the interaction energy of the intermolecular bonds at stake could be divided into various physically meaningful components such as electrostatic, exchange, dispersion, relaxation, etc. Yet, none of the above components could be clearly called "covalent," inasmuch as anti-bonding mixing of atomic orbitals is likely to be involved, rather than bonding mixing. Should substantial charge-transfer be involved and be regarded as a coordinate-covalent interaction, the occurrence of a substantial overlap repulsion (i.e., the exchange component) would not make the molecules be viewed as covalently bonded.

Rather, the intermolecular bonds provide a better comprise than the usual chemical bonds, inasmuch as the film can remain stable under normal conditions, less energy being yet required at the probe to create the patterns.

In this regards, patterning the film is carried out by means of a nano-scale dimensioned probe, which is further heated, such as to desorb molecules when interacting with (e.g., urged against) the film. In other words, molecules evaporate upon interaction with the probe. The probe thereby directly engraves patterns into the film.

Both the temperature of the probe and the time of exposure of the probe to the surface can be adjusted according to a characteristic of the cross-linked molecules, in order to achieve desired desorption performances. The average desorption energy of the molecules can be seen as such a characteristic, which is impacted by the intermolecular bonds.

Since the binding energy caused by the intermolecular links is small (at least compared to covalent links), the process can work at moderate temperatures and short probe-sample interaction times. This, in turns, allows for scaling to fast writing times.

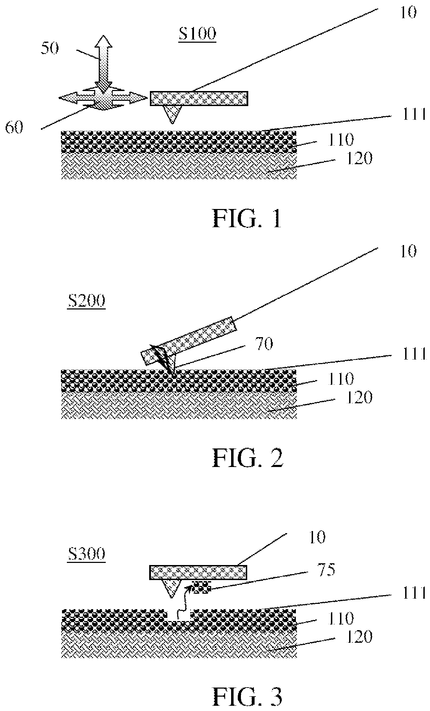

In reference to FIG. 1, a material is provided, having a polymer film 110 on a substrate 120. The film includes a network of molecules which are cross-linked via intermolecular bonds.

The probe 10 is an AFM probe mounted on the end of a cantilever, as schematically represented in FIG. 1. At the apex thereof, the osculating radius is typically between 5 to 10 nm. More generally, dimensions of the probe are in the nanometer scale. The probe is part of an AFM device (not shown), comprising electronic circuitry suitably designed to measure and control, in operation, an interaction between the probe 10 and a sample surface 111.

Engineering solutions may further be provided such that it is possible to accurately control the relative position of the probe and surface, and possibly to ensure good vibrational isolation of the AFM. This can, for instance, be achieved using sensitive piezoelectric positioning devices, as known in the art. Both vertical 50 and horizontal 60 controls of the probe are thus typically provided together with the AFM.

In a usual AFM device, the probe 10 is likely to be raster scanned above the sample surface, such that imaging of the surface topology can be carried out. Here, the probe 10 will rather be used to engrave patterns on the surface 111, as to be explained in reference to FIGS. 1 - 5.

How the surface is patterned can be decomposed into several substeps. First, the probe 10 is maintained in a "non-patterning position," that is, close to the surface 111 of the film 110 (step S100, FIG. 1). The probe is not yet close (or urged) enough to enable surface patterning. More generally, conditions applied to the probe do, in a first substep, not allow for engraving a pattern.

FIG. 2 is very similar to FIG. 1, except that the probe 10 is now urged against the surface 111 of the film, and interacts therewith. The interaction 70 is likely to desorb one or more molecules75, as illustrated in FIG. 3.

In some embodiments, the probe temperature (*Tₚ*) and the time (*tₑ*) of exposure of the probe to the surface are suitably adjusted, such as to change or optimize desorption of molecules. For example, the parameters may be adjusted so as to obtain regular patterns while minimizing the exposure time. Accordingly, high rates of primitive patterning can be achieved. In some embodiments, these are close to or even greater than one megahertz (MHz).

Incidentally, a person skilled in the art may appreciate in light of the subject matter described herein that, for a given load force, the above parameters (*Tₚ, tₑ*) determine the desorption process, inasmuch as its rate constant roughly obeys, in a simple physical picture, the law *r* = *Ae-^{E}ₐ*^{/}*^{k_{B}T}.* Here, *A* is the "attempt frequency," that is, the chance of a molecule to overcome its potential barrier to desorption, which is partly determined by the exposure time. Furthermore, *Eₐ* is the activation energy of desorption of the cross-linked molecules, *k_{B}* is Boltzmann's constant, and *T* is the temperature.

In addition, the skilled person may appreciate in light of the subject matter described herein that the force applied to the probe while patterning may suitably be adapted in respect of the sample. Basically, in one embodiment, both temperature and force pulses are applied to the probe, at positions where the molecules are to be removed. Quantitative details are provided below.

The desorption of a molecule 75 is depicted in FIG. 3. In some embodiments, an assembly of molecules is likely to be desorbed by the probe, during a single exposure, that is, a single indent step, whereby pattern primitives are engraved. More specifically, the molecules are desorbed, that is, evaporated by the heated probe 10, instead of the film being thermomechanically indented or locally melted. Next, shortly before or after the molecule desorption, the probe is released to its non-patterning position, as in FIG. 1.

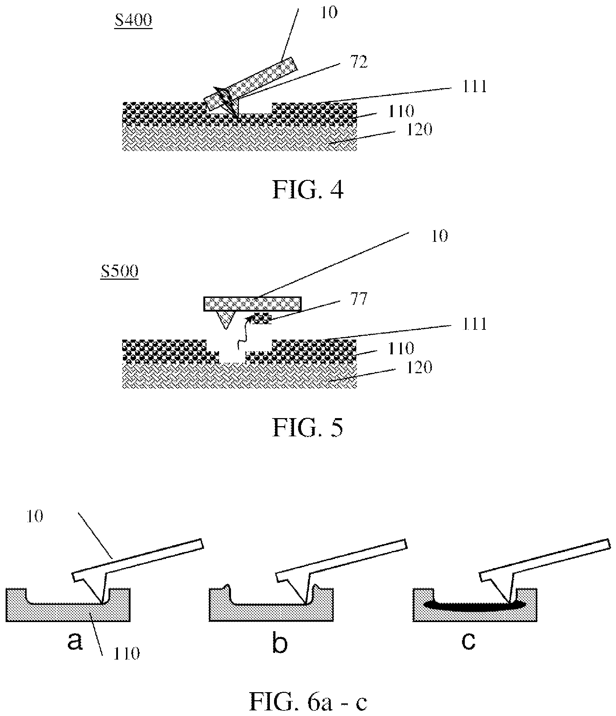

The resulting material has nano-scale patterns of molecules on its surface. By heating this material above a certain temperature, it is locally evaporated, as sketched in FIG. 6a. An advantage of using evaporation, in some embodiments, is that evaporated material is significantly and/or completely removed from the sample and not only pushed aside, in contrast to an elastic deformation were rims are formed at the edges of the pattern (as in FIG. 6b), or the density is locally increased (FIG. 6c). The latter case is potentially disadvantageous when a subsequent etch step is to be contemplated.

Now, the patterns obtained so far are merely bidimensional inasmuch as no information can be exploited from the depth of the pattern. Rather, a gradient of depth would be required to encode information. In this regards, the present invention can be embodied such as to create three-dimensional (3D) patterns of molecules in the film, as illustrated in FIGS. 4 - 5.

To this aim, one may first engrave a first pattern of molecules at a given location on the film, as represented in FIG. 4. Then, a second pattern can be created within the first pattern, as depicted in FIG. 5. In other words, repeated exposures are carried out. This amounts to engrave a pattern within an already existing pattern. Repeated exposures may achieve a pattern as depicted in FIG. 5, unless one or more parameters are varied during a single exposure. Incidentally, since such a method is maskless, there is comparatively little overhead associated therewith as compared to optical lithography, where several masks are fabricated and applied.

Alternatively, direct 3D-patterning in a single exposure step can be attained by adjusting an evaporation volume at each location on the surface that is exposed. For example, one may contemplate modulating the force applied to the probe during an exposure, e.g., using electrostatic actuations. Varying the force applied during an exposure results in a pattern with modulated depth. Similarly, direct 3D-patterning can further be controlled by varying the temperature of exposure (using e.g. an integrated heater in the probe tip), or the exposure time.

Accordingly, a continuous change of topography can be carried out. This way, 3D patterns can be obtained within a single exposure, i.e., a single indent step. Depth modulated patterns are likely to allow for a dramatic improvement of a writing density. Incidentally, varying any of the above parameters (force, temperature, exposure time) or a combination thereof can already be contemplated for creating 2D patterns.

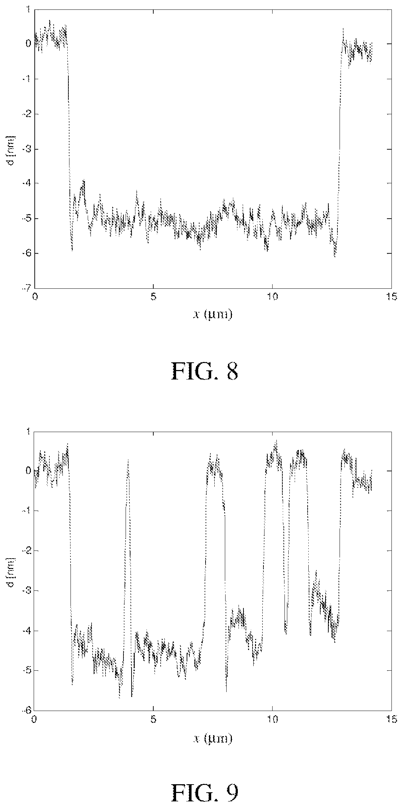

In addition, before the proper patterning steps, the depth of indents may be calibrated as a function of applied load and temperature, so as to set specific and/or optimal working conditions. For example, for a patterning depth of around 4 nm, a temperature of 300°C and a load force of 80 nN may result to be optimal (especially for films as described below). Within such conditions, writing indents with a pitch of 23 nm typically yields uniform removal of material over large areas. This results in patterned areas with distinct patterning depths, as discussed below with reference to FIGS 8 - 10. More generally, load forces of 50 - 100 nN may be convenient.

Furthermore, the ability to image the surface prior to patterning enables very accurate positioning. This becomes important notably when it comes to patterning very fine features at high resolution over a pre-patterned surface with features that do not require such a high resolution (and which can be realized using more conventional patterning mechanisms with much higher throughput). Once the pattern is written, it is possible to image it before further processing steps. A post-imaging allows for quality control of the written pattern and its eventual correction.

At present, variants as to the types of suitable polymers are discussed.

The average molecular mass of molecules within the
film is less than about 4000 dalton (Da, IDa= 1u), in order to enable a desorption process. Yet,
tests have shown that molecular masses in the approximate range from 100 Da to 2000 Da may make the process easier. More specifically, masses in the approximate range from 150 Da to 1000 Da may allow for increased and/or optimal desorption, at least for specific samples.

As described above, the molecules are cross-linked via e.g., hydrogen bonds. A hydrogen bond is typically defined as the attractive force occurring between a hydrogen atom attached to an electronegative atom of a first molecule and an electronegative atom of a second molecule. While its energy can be compared to that of the weakest covalent bonds, the underlying physics cannot. Incidentally, a typical covalent (bonding) bond is about twenty times stronger than a typical hydrogen bond. Accordingly, relatively low desorption temperature and short interaction times can be contemplated in practice.

In one embodiment, the average desorption energy of the molecules is approximately in the range from 2eV to 3eV, as the result of various intermolecular links in the media (including long-distance interactions). More generally, desorption energies approximately between 1 and 4 eV may be convenient.

Closely related, the temperature of the heated probe is approximately between 300°C and 600°C. In some embodiments, it is approximately between 300°C and 500°C, which may be optimal in some cases. As a side note, the temperature of the probe is believed to be about twice as much as the temperature of the desorbing molecules.

Meanwhile exposure times are typically in the range of 1 microsecond (µs) and 10 µs. Yet, in some embodiments, it is possible to set the exposure time to about 0.3 µs, with acceptable results. Roughly, exposure times of less than about 1 µs allows for indent rates of 1 MHz.

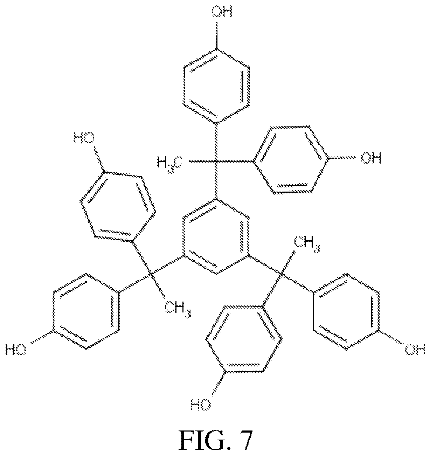

Next, the network of molecules forming the film includes molecular
glasses. An example of a molecular glass molecule is represented in FIG. 7 (phenolic compound). Such molecules include small molecules (with molecular masses typically of about 1000 Da). These molecules do not properly crystallize due to a large number of configurations with merely equivalent conformational energy. At the periphery of the molecules, hydrogen bonding groups (Hydroxyl) establish the physical links between the molecules.

The deposition of a thin film of this material onto a substrate (e.g., Si-wafer) is simply done by spin-coating a solution of molecular glass, followed by a brief annealing step (e.g., about 1 minute at 130 °C) to drive out the solvent. No further cross-linking reaction is required.

Due to the high number of hydrogen bonding interactions, the polymer exhibits a relatively high glass transition temperature, *T_{g}*. In short, below the temperature *T_{g}*, the structure of the polymer can be termed glassy, as it has a merely random arrangement of chains, similar to molecular arrangements seen in glasses. In some embodiments, *T_{g}* is of about 120°C, which is suited for use in patterning. More generally, the glass transition temperature is approximately between 80°C to 160°C, and in some embodiments between 100°C and 130°C (e.g. 120°C), which may be more suited for patterning in practice. Furthermore, hydrogen bonds make the material stable against repeated scanning with the probe. It is accordingly suitable for use in the contexts of storage and lithography, for mask-repair and inspection.

A proof of concept has been successfully performed by using a substrate prepared as already mentioned. With typical writing conditions, patterns have been structured onto the polymer media. Specifically, the patterned surface at stake is made of a polymer of molecular glass molecules, cross-linked via hydrogen bonds. A load force of about 80nN was used to indent the patterns, together with a probe temperature of nearly 400°C. The surface image was then obtained with the same AFM probe as used to pattern.

FIGS 8 - 9 show typical experimental cross sections of topographic images of the surface. Deflections *d* are in nm, while the *x*-coordinate is in µm. As shown by the graphs, satisfactorily clean patterns are obtained, with vertical resolution of about 1 nm or less. The depth of the patterned features is of around 5 nm, as measured from the profiles. Here, it is possible to acknowledge the approximately constant depth of the patterned features, and thus their uniformity. The second peak corresponds to a patterned feature having a width of about 30 nm. Even smaller features could actually be contemplated since the resolution in *x* is currently of 5-10 nm.

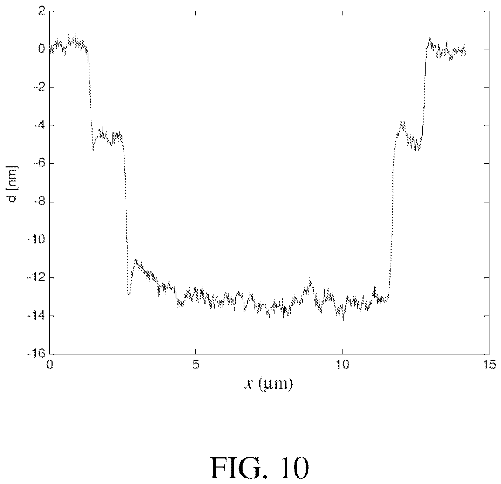

In FIG. 10, the cross section pertains to a sample surface patterned according to a 3D patterning scheme as discussed above. Specifically, the surface is patterned by repeating exposures with same or similar conditions over an already exposed feature (i.e., a pattern). The features of the polymer film and experimental conditions used are otherwise the same as those leading to FIGS. 8 - 9. Again, clean 3D patterns are obtained. The vertical resolution remains less than 1 nm.

Next, it is pointed at the fact embodiments discussed above present significant advantages in terms of pattern transfer. In this regards, pattern transfer into silicon can be performed by using standard dry-etching technique directly on a patterned molecular glass that serves as the resist.

In an experimental test, the etch conditions used were 20 seconds in a deep-reactive-ion etching tool, using a standard process gas mixture of 50% SF₆ and 50% C₄F₈. The resulting pattern in silicon reflected the topography of the pattern in the molecular glass. Yet, amplification of the pattern in the vertical axis could be controlled via the processing conditions. In particular, the pattern was amplified five times.

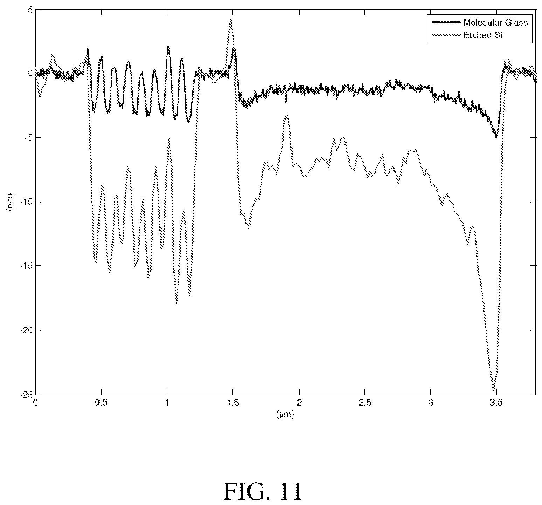

The results are illustrated in FIG. 11. The upper black curve pertains to the molecular glass surface. The lower grey curve relates to the etched Si surface. As can be appreciated, the quality of the transfer is satisfactory.

Lastly, a final experiment is briefly discussed. In this experiment, a molecular organic glass is patterned. A thin film of 10-100 nm thickness is prepared by spin-coating or evaporation. By fine-tuning the inter-molecular interaction, the material can be desorbed by applying a thermomechanical trigger, i.e., a probe, leaving behind a well defined void. The probe tip temperature and the mechanical force are on the order of 300 - 500 °C and 50 - 100 nN, respectively. By laterally displacing the probe and repeating the process, any arbitrary pattern can be written, the resolution of the process being determined by the apex dimensions of the probe. The patterns are written with a pitch of 29 nm, corresponding to 5× 104 written marks, resulting in uniformly recessed structures of 8±1 nm depth. The volume of material contained in the box amounts to 0.2 µm3, yet no traces of material displacement or material redeposition are found. Similarly, no material pick-up by the probe tip could be detected by SEM after writing. Next, the structured glass could be used without any development step as a selective etch mask. Using a three layer technique and exploiting etch rate selectivities between organic materials and silicon/silicon oxide, it is possible to transfer the structure into silicon with excellent shape conformity.

In addition, material removal could be accumulated, thereby enabling the fabrication of three-dimensional structures. As a test, a replica of the Matterhorn was accomplished by consecutive removal of molecular glass layers with defined thickness. An almost perfect conformal reproduction of the original was obtained, proving that the final structure is a linear superposition of well defined single patterning steps. Moreover, results made it clear that the organic material is neither densified nor chemically altered during patterning.

The unique capabilities of embodiments of the technology recited above open up new perspectives, notably for the fabrication of complex textured substrates for guided and directed assembly of shape-matching objects. The technique further offers a competitive alternative in terms of resolution and speed to known techniques, such as high-resolution electron beam lithography.

## Claims

1. A probe-based method for patterning a surface of a material, the method comprising:
providing a material having a polymer film with a network of molecules cross-linked via intermolecular, non essentially covalent bonds; and
patterning the polymer film by desorbing molecules from the network with a heated, nano-scale dimensioned probe,
wherein,
at the step of providing, the network of molecules in the material provided comprises molecules of molecular glasses and an average molecular mass of the molecules in the polymer film is between 100 u and 2000 u

2. The method of claim 1, wherein, at the step of providing, the average molecular mass of the molecules in the polymer film is within a range from 150 u to 1000 u.

3. The method of claim 1, wherein, at the step of providing, the molecules of the network in the material are cross-linked via hydrogen bonds.

4. The method of claim 1, wherein, at the step of providing, a glass transition temperature of the material is between 80°C to 160°C, preferably between 100°C and 130°C.

5. The method of claim 1, wherein, at the step of providing, an average desorption energy of the molecules in the polymer film is between 1 eV and 4 eV, preferably between 2 eV and 3 eV.

6. The method of claim 1, wherein, at the step of patterning, a temperature of the heated probe is between 300°C and 600°C, and an exposure time is between 0.3 microsecond and 10 microseconds.

7. The method of claim 1, further comprising, prior to providing the material:
spin-coating a solution of molecular glass onto a substrate; and
annealing the coated solution.

8. The method of claim 1, wherein the patterning further comprises patterning a three-dimensional pattern of molecules in the polymer film.

9. The method of claim 8, wherein the patterning further comprises:
patterning at a given location on the polymer film a first pattern of molecules; and
patterning a second pattern of molecules within the first pattern.

10. The method of claim 8, wherein the patterning further comprises varying at least one probe parameter of a plurality of probe parameters, wherein the plurality of probe parameters comprise a force applied to the probe, a temperature of the probe, and an exposure time for patterning a pattern of molecules.

## Patentansprüche

1. Verfahren auf Sondenbasis zum Strukturieren einer Oberfläche eines Materials, wobei das Verfahren aufweist:
Bereitstellen eines Materials, welches eine Polymerdünnschicht mit einem Netzwerk von Molekülen aufweist, die über intermolekulare, nicht notwendigerweise kovalente Bindungen vernetzt sind; und
Strukturieren der Polymerdünnschicht durch Desorbieren von Molekülen aus dem Netzwerk mit einer erwärmten Sonde, die im Nanomaßstab dimensioniert ist,
wobei
im Schritt des Bereitstellens das Netzwerk von Molekülen in dem bereitgestellten Material Moleküle von Molekularglasen aufweist und eine mittlere Molekularmasse der Moleküle in der Polymerdünnschicht 100 u bis 2.000 u beträgt.

2. Verfahren nach Anspruch 1, wobei im Schritt des Bereitstellens die mittlere Molekularmasse der Moleküle in der Polymerdünnschicht in einem Bereich von 150 u bis 1.000 u liegt.

3. Verfahren nach Anspruch 1, wobei im Schritt des Bereitstellens die Moleküle des Netzwerks in dem Material über Wasserstoffbrücken-Bindungen vernetzt sind.

4. Verfahren nach Anspruch 1, wobei im Schritt des Bereitstellens eine Glasübergangstemperatur des Materials 80 °C bis 160 °C, vorzugsweise 100 °C bis 130 °C beträgt.

5. Verfahren nach Anspruch 1, wobei im Schritt des Bereitstellens eine mittlere Desorptionsenergie der Moleküle in der Polymerdünnschicht 1 eV bis 4 eV, vorzugsweise 2 eV bis 3 eV beträgt.

6. Verfahren nach Anspruch 1, wobei im Schritt des Strukturierens eine Temperatur der erwärmten Sonde 300 °C bis 600 °C beträgt und eine Einwirkungszeit 0,3 Mikrosekunden bis 10 Mikrosekunden beträgt.

7. Verfahren nach Anspruch 1, vor dem Bereitstellen des Materials ferner aufweisend:
Aufschleudern einer Lösung von Molekularglas auf ein Substrat; und
Tempern der aufgeschichteten Lösung.

8. Verfahren nach Anspruch 1, wobei das Strukturieren ferner Erzeugen einer dreidimensionalen Struktur von Molekülen in der Polymerdünnschicht aufweist.

9. Verfahren nach Anspruch 8, wobei das Strukturieren ferner aufweist:
Erzeugen einer ersten Struktur von Molekülen an einer gegebenen Stelle auf der Polymerdünnschicht; und Erzeugen einer zweiten Struktur von Molekülen innerhalb der ersten Struktur.

10. Verfahren nach Anspruch 8, wobei das Strukturieren ferner Variieren mindestens eines Sondenparameters einer Mehrzahl von Sondenparametern aufweist, wobei die Mehrzahl von Sondenparametern eine auf die Sonde angewendete Kraft, eine Temperatur der Sonde und eine Einwirkungszeit zum Erzeugen einer Struktur von Molekülen umfasst.

## Revendications

1. Procédé à base d'une sonde pour une application de motifs sur une surface d'un matériau, le procédé comprenant :
la fourniture d'un matériau ayant un film de polymère avec un réseau de molécules réticulées via des liaisons intermoléculaires, non essentiellement covalentes ; et
l'application de motifs sur le film de polymère par la désorption de molécules à partir du réseau avec une sonde d'une taille à l'échelle du nanomètre, chauffée,
où
au cours de l'étape de fourniture, le réseau des molécules dans le matériau mis à disposition comprend des molécules de verres moléculaires et une masse moléculaire moyenne des molécules dans le film de polymère est entre 100 u et 2000 u.

2. Procédé selon la revendication 1, dans lequel, au cours de l'étape de fourniture, la masse moléculaire moyenne des molécules dans le film de polymère est dans une gamme de 150 u à 1000 u.

3. Procédé selon la revendication 1, dans lequel, au cours de l'étape de fourniture, les molécules du réseau dans le matériau sont réticulées via des liaisons d'hydrogène.

4. Procédé selon la revendication 1, dans lequel, au cours de l'étape de fourniture, une température de transition vitreuse du matériau est entre 80 °C et 160 °C, de préférence entre 100 °C et 130 °C.

5. Procédé selon la revendication 1, dans lequel, au cours de l'étape de fourniture, une énergie moyenne de désorption des molécules dans le film de polymère est entre 1 eV et 4 eV, de préférence entre 2 eV et 3 eV.

6. Procédé selon la revendication 1, dans lequel, au cours de l'étape d'application des motifs, une température de la sonde chauffée est entre 300 °C et 600 °C, et une durée de l'exposition est entre 0,3 microseconde et 10 microsecondes.

7. Procédé selon la revendication 1, comprenant en outre, antérieurement à la fourniture du matériau :
l'application par centrifugation d'une solution de verre moléculaire sur un substrat ; et
le recuit de la solution de revêtement.

8. Procédé selon la revendication 1, dans lequel l'application de motifs comprend en outre l'application d'un motif tridimensionnel de molécules dans le film de polymère.

9. Procédé selon la revendication 8, dans lequel l'application de motifs comprend en outre :
l'application à un endroit donné sur le film de polymère d'un premier motif de molécules ; et
l'application d'un second motif de molécules dans le premier motif.

10. Procédé selon la revendication 8, dans lequel l'application de motifs comprend en outre la variation d'au moins un paramètre de la sonde d'une pluralité de paramètres de la sonde, où la pluralité des paramètres de la sonde comprend une force appliquée à la sonde, une température de la sonde, et une durée de l'exposition pour l'application d'un motif de molécules.
